(19) Europäisches Patentamt / European Patent Office / Office européen des brevets

(11) **EP 3 218 941 B1**

(12) **EUROPEAN PATENT SPECIFICATION**

(45) Date of publication and mention of the grant of the patent:
**22.08.2018 Bulletin 2018/34**

(21) Application number: **15793809.3**

(22) Date of filing: **11.11.2015**

(51) Int Cl.:
*H01L 35/08* (2006.01)     *H01L 35/18* (2006.01)
*B23K 35/26* (2006.01)     *H01L 35/34* (2006.01)

(86) International application number:
**PCT/EP2015/076291**

(87) International publication number:
**WO 2016/075185 (19.05.2016 Gazette 2016/20)**

(54) **METHOD FOR PRE-PROCESSING SEMICONDUCTING THERMOELECTRIC MATERIALS FOR METALLIZATION, INTERCONNECTION AND BONDING**

VERFAHREN ZUR VORVERARBEITUNG VON HALBLEITENDEN THERMOELEKTRISCHEN MATERIALIEN ZUR METALLISIERUNG, VERBINDUNG UND VERKLEBUNG

PROCÉDÉ DE PRÉTRAITEMENT DE MATÉRIAUX THERMOÉLECTRIQUES SEMI-CONDUCTEURS POUR MÉTALLISATION, INTERCONNEXION ET SOUDAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.11.2014 NO 20141357**

(43) Date of publication of application:
**20.09.2017 Bulletin 2017/38**

(73) Proprietor: **Tegma AS**
**4623 Kristiansand (NO)**

(72) Inventors:
- **TOLLEFSEN, Torleif A.**
  **N-4633 Kristiansand (NO)**
- **ENGVOLL, Marianne Aanvik**
  **N-4625 Flekkerøy (NO)**
- **LØVVIK, Ole Martin**
  **N-0884 Oslo (NO)**
- **LARSSON, Andreas**
  **N-3413 Lier (NO)**

(74) Representative: **Onsagers AS**
**Munkedamsveien 35**
**P.O. Box 1813 Vika**
**0123 Oslo (NO)**

(56) References cited:
**US-A- 5 429 680**     **US-A1- 2013 152 990**
**US-A1- 2014 096 809**     **US-A1- 2014 109 948**
**US-A1- 2014 305 483**

- **LAETITIA BOULAT ET AL: "Diffusion barriers for CeFe4Sb12/Cu thermoelectric devices", MRS PROCEEDINGS, vol. 1490, 1 January 2013 (2013-01-01), XP055246348, DOI: 10.1557/opl.2013.218**
- **TORLEIF A TOLLEFSEN ET AL: "Au-Sn SLID Bonding-Properties and Possibilities", METALLURGICAL AND MATERIALS TRANSACTIONS B, SPRINGER-VERLAG, NEW YORK, vol. 43, no. 2, 1 December 2011 (2011-12-01), pages 397-405, XP035031877, ISSN: 1543-1916, DOI: 10.1007/S11663-011-9609-Z**

## Description

The present invention relates to a method for pre-processing semiconducting thermoelectric materials for metallization, interconnection and bonding to form a thermoelectric device, and thermoelectric devices utilising the pre-processed processing semiconducting thermoelectric materials made by the method.

## Background

The Seebeck effect is one of three possible expressions of the thermoelectric effect, namely the direct conversion of thermal energy to electric energy found in some materials when subject to a temperature gradient creating a heat flux through the material. The Seebeck effect will when connecting the material to a heat sink on one side and a heat source on the opposite side, create an electric potential which may be utilised for driving an electrical device or charging a battery. The thermoelectric conversion efficiency is dependent on the ratio electric over thermal conductivity and is usually defined as the dimensionless figure of merit, ZT:

$$ZT = \frac{\sigma S^2}{\kappa} \cdot T \qquad (1)$$

where $\sigma$ is electric conductivity, S is a thermoelectric coefficient often termed the Seebeck-coefficient, $\kappa$ is thermal conductivity, and T is absolute temperature.

Skutterudite is a class of minerals discovered at Skutterud in Norway in 1827, often denoted by the general formula $TPn_3$, where T is a transition metal such as i.e.; Co, Rh, In, Fe, and Pn is one of the pnictogens (member of the nitrogen group in the periodic table); P, As or Sb.

The unit cell of the skutterudite structure contains 32 atoms arranged into the symmetry group Im3 as shown schematically in figure 1a), which is a facsimile of Figure 1 of US 6 660 926. The cation in the mineral is the transition metal with an oxidation number of +III. The anion is a radical with oxidation number - IV and consist of four Pn atoms (reference number 120) arranged in a four membered planar ring (reference number 120). The cations (reference number 110) are arranged in a cubic pattern defining a large cube made up of eight smaller cubes, each having a cation at their eight corners. In six of these smaller cubes, there is inserted one anion, and two of the smaller cubes are vacant. Thus, the structure of skutterudite may also be given as: $T_8^{+III}[Pn_4^{-IV}]_6$.

The skutterudite is semiconducting when electric neutral, that is, maintains a ratio of T:[Pn₄] = 4:3. Further, due to its covalent bonding structure, the skutterudite crystal lattice has a high carrier mobility. At the same time, the complexity of the crystal lattice combined with the heavy atoms results in a relatively low thermal conductivity, so that semiconducting skutterudites often have a favourable electric over thermal conductivity ratio and thus promising figures of merit, ZT.

Semiconducting materials conduct electricity by using two types of charge carriers; electrons and holes (vacant electron sites in the crystal lattice atoms). By doping, i.e. substituting one or more of the T atoms in the crystal lattice with an atom of another element, the semiconducting material can be made to dominantly conduct electric charges by either electrons (n-type conductivity) or holes (p-type conductivity), depending on which dopant (substitute element) being introduced.

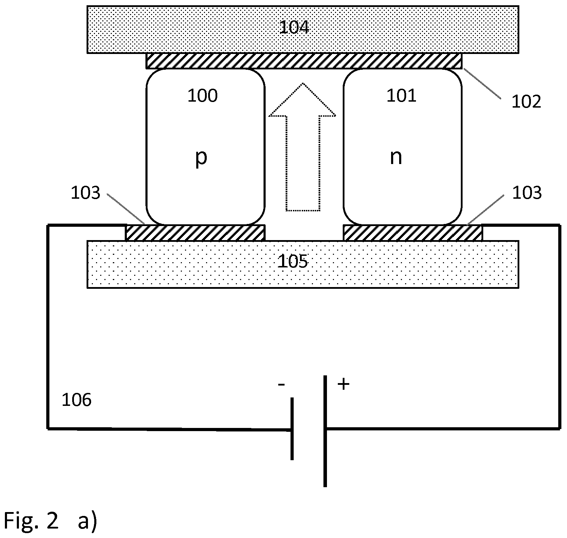

An n-type and a p-type semiconductor may be electrically connected to form an electric circuit as schematically illustrated in figure 2a). In the figure, an object 100 of n-type semiconducting material is in one end electrically connected to an object 101 of p-type semiconducting material by electric contact 102. At the opposite ends, the objects 100 and 101 are separately connected to one electric conductor 103. The electric conductors 103 may be connected together by an external electric circuit 106, in which, electric current will flow as long as charge carrier couples (separate electrons and holes) are created in the semiconducting materials. In a thermoelectric semiconducting material, charge carrier couples are made when heat flows through the material. Thus, by making the electrodes 103 in thermal contact with a heat reservoir 105 and the opposite electrode 102 in thermal contact with a heat sink 104, a heat flux will flow through the semiconducting materials 100 and 101 in the direction indicated by the arrow, and an electric current will flow from the n-type semiconductor to the p-type semiconductor as long as the external electric circuit 106 is closed.

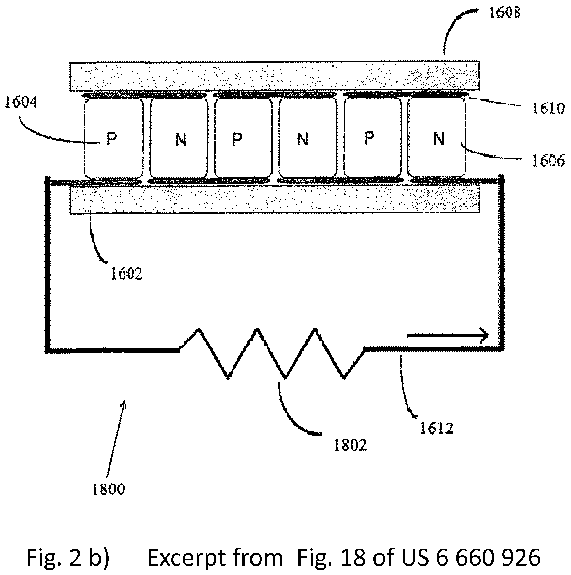

The configuration shown in Figure 2 a) constitutes the basic principle of how thermoelectric devices may be constructed. In practice, there will usually be employed several n-type and p-type semiconducting materials electrically connected in series and thermally connected in parallel as shown in i.e. figure 2 b), which is a facsimile of figure 18 of US 6 660 926.

A thermoelectric device of this kind may provide a compact, highly reliable, long lasting, and noiseless and pollution free manner of generating electric power from a heat source.

## Prior art

US 6 660 926 discloses that the thermal conductivity of skutterudite can be reduced, and thus obtain a higher figure of merit, by filling the two vacant smaller cubes of the 32-atom unit cell with a binary compound and in addition substituting elements to replace part of the original transition metal and/or pnictogen elements to conserve the valence electron count of the unit cell. The document discloses several examples of such materials having high ZT-values, of which one is

$CeFe_{4-x}Co_xSb_{12}$.

From WO 2011/014479 it is known that owing to its large crystal cells, heavy atomic mass, large carrier mobility and disturbance of filled atoms in the Sb-dodecahedron, thermoelectric materials of $CoSb_3$ based skutterudite exhibit superior thermoelectric properties at temperatures in the range from 500 to 850 K. The document discloses that the n-type skutterudite $Yb_yCo_4Sb_{12}$ has a ZT of 1.4 and that p-type skutterudite $Ca_xCe_yCo_{2.5}Fe_{1.5}Sb_{12}$ has a ZT of 1.2. The document discloses further that at 850 K, the vapour pressure of Sb is about 10 Pa, leading to a serious degradation of the semiconductor due to loss of the element Sb. The solution to this problem according to WO 2011/014479 is to coat the skutterudite material with a first metal layer and a second metal oxide layer. The metal layer may be one of; Ta, Nb, Ti, Mo, V, Al, Zr, Ni, NiAl, TiAl, NiCr, or an alloy of two or more of them; and the metal oxide may be one of $TiO_2$, $Ta_2O_5$, $Al_2O_3$, $ZrO_2$, $MO_2$, $SiO_2$, or a composite of two or more of them, or a multi-layer of two or more of them.

According to US 6 673 996, skutterudite is the only known single thermoelectric material suitable for use over the temperature range from room temperature up to about 700 °C. The document describes $CeFe_4Sb_{12}$ based alloys and $CoSb_3$ based alloys as suited materials for p-type and n-type thermoelectric materials, respectively. On the cold side, the thermoelectric materials are connected to a cold shoe made of $Al_2O_3$ coated with a layer of Cu to provide the electric and thermal contact. In order to protect the thermoelectric material from indiffusion of Cu, there is employed a diffusion barrier of Ni which is formed onto the Cu-layer by electroplating.

Another example of employing $CoSb_3$ based skutterudite as thermoelectric material in a thermoelectric device is shown in US 6 759 586. In this document there is disclosed a thermoelectric device comprising a piece of $CoSb_3$ based skutterudite as either n-type or p-type conductivity attached to an electrode made of a Fe-alloy or an Ag-alloy, and which employs a diffusion barrier between the skutterudite and the electrode made of Sb and one of Au, Ag or Cu.

From WO 2012/071173 it is known a thermoelectric device using skutterudite as the thermoelectric conversion material which is covered with a thin barrier layer deposited by atomic layer deposition. Examples of suited barrier layers include metal oxides such as; $Al_2O_3$, $TiO_2$, $Ta_2O_5$, $SnO_2$, ZnO, $ZrO_2$, and $HfO_2$), and metal nitrides such as; $SiN_x$, TiN, TaN, WN, and NbN).

EP 2 242 121 describes a certain class of filled skutterudite suited for being used as thermoelectric conversion material at temperatures in the range from 20 to 600 °C. The group is defined by the general formula: $R_rT_{t-m}M_mX_{x-n}N_n$ ($0 < r \leq 1,3 \leq t-m \leq 5$, $0 \leq m \leq 0.5$, $10 \leq x \leq 15$, $0 \leq n \leq 2$), where R represents three or more elements selected from the group consisting of rare earth elements, alkali metal elements, alkaline-earth metal elements, group 4 elements, and group 13 elements, T represents at least one element selected from Fe and Co, M represents at least one element selected from the group consisting of Ru, Os, Rh, Ir, Ni, Pd, Pt, Cu, Ag, and Au, X represents at least one element selected from the group consisting of P, As, Sb, and Bi, and N represents at least one element selected from Se and Te. The document discloses further that in order to obtain a good junction between the thermoelectric conversion material end the electrodes of the thermoelectric device, it should be employed a joining layer between these phases comprising an alloy with a composition adjusted to match the thermal expansion coefficient of the thermoelectric conversion material. Examples of suited alloys for use as the joining layer includes titanium alloy of 50 to 100 weight% Ti, and from 0 to 50 weight% of at least one of Al, Ga, In, and Sn. In another example, the joining layer is made of a nickel alloy of 50 to 100 weight% Ni, and from 0 to 50 weight% of Ti. The electrode may be an alloy selected from the group of; titanium alloys, nickel alloys, cobalt alloys, and iron alloys.

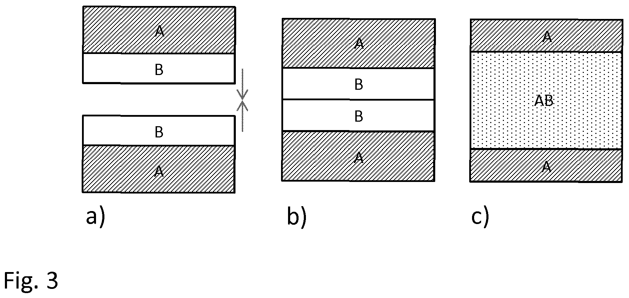

Bader et al. 1994 [1] has studied bonding two metals together by use of solid-liquid interdiffusion (SLID) bonding, where a low melting point metal and a high melting point metal are bonded together by forming an intermetallic compound of the two metals at their joint. In one example, the document discloses bonding two pieces of nickel, each having a tin layer on one side, by gently pressing the sides with tin layers against each other and heating the pieces until the tin melts and maintaining the gentle pressure and the temperature until all liquid tin has reacted with the nickel and formed a solid Ni-Sn intermetallic compound which securely bonds the metal pieces together, as illustrated schematically in figures 3 a) to c). From the Ni-Sn phase diagram presented in the document we have that the melting point of Sn is 232 °C, while all of the possible intermetallic compounds, $Ni_3Sn$, $Ni_3Sn_2$, and $Ni_3Sn_4$, have a melting noint above 800 °C. US 2013/0152990 discloses use of the SLID-technology for bonding electrodes to thermoelectric conversion materials. The document mentions $Bi_2Te_3$, GeTe, PbTe, $CoSb_3$, and $Zn_4Sb_3$ as examples of thermoelectric conversion materials, and the thermoelectric conversion material is first coated with a 1 to 5 $\mu$m thick barrier layer of Ni or other suited material, then with a 2 - 10 $\mu$m thick Ag, Ni or Cu layer, and finally with 1-10 $\mu$m thick Sn layer. The electrode is on one side first coated with a 2 - 10 $\mu$m thick Ag, Ni or Cu layer, and then with 1 - 10 $\mu$m thick Sn layer. The coated thermoelectric conversion material and the electrode are then laid with their Sn layers side by side and pressed together under a gentle heating until the Sn layers melt and react with the Ag, Ni or Cu to form solid intermetallic compounds bonding the electrode to the thermoelectric conversion material.

US2014/0305483 discloses a method for fabricating a multi-layer thermoelectric module using a solid-liquid interdiffusion jointing technique.

## Objective of the invention

The main objective of the present invention is to provide a simple, cost-effective and robust method of pre-processing semiconducting thermoelectric materials for metallization, interconnection and bonding to form a thermoelectric device.

A further objective is to provide pre-processed thermoelectric materials made by the method, and in particular, filled and not filled $CoSb_3$-based skutterudite thermoelectric conversion materials.

## Description of the invention

The invention is based on the realisation that a cost-effective, simple and resilient interconnection and bonding of semiconducting thermoelectric materials to the electrodes of thermoelectric devices, may be obtained by employing the solid-liquid interdiffusion bonding concept in combination with use of an adhesion layer /diffusion barrier layer/adhesion layer structure (interchangeably also termed as; the ADA-structure) in-between the solid-liquid interdiffusion bonding layers and the semiconducting thermoelectric material.

Thus in a first aspect, the present invention relates to a method for forming a pre-processed semiconducting thermoelectric conversion material for metallization, interconnection and bonding, wherein the method comprises the following process steps in successive order:

- employing at least one element of a n-type or p-type doped semiconducting thermoelectric conversion material having a first and second surface on opposite sides,
- placing the at least one element of semiconducting thermoelectric conversion material into a deposition chamber, and then:

  i) depositing a first adhesion layer of a first metal directly onto the first and the second surface of the element of the semiconducting thermoelectric conversion material,
  ii) depositing a diffusion barrier layer of a non-metallic compound of a second metal directly onto the first adhesion layer on the first and second surface of the semiconducting thermoelectric conversion material element,
  iii) depositing a second adhesion layer of a third metal directly onto the diffusion barrier layer of the non-metallic compound of the second metal on the first and second surface of the element of the semiconducting thermoelectric conversion material,

  wherein

- the deposition chamber is either a chemical vapour deposition chamber, a physical vapour deposition chamber, or an atomic deposition chamber, and the deposition of the different layers of steps i) to iii) is obtained by feeding precursor gases with varying chemical composition into the deposition chamber,
- the non-metallic compound of the second metal is either a nitride or an oxide of the second metal,

- depositing a first bonding layer of a metal A directly onto the second adhesion layer on the first and second surface of element of the semiconducting thermoelectric conversion material, and
- depositing a second bonding layer of a metal B directly onto the first bonding layer the on the first and second surface of the element of the semiconducting thermoelectric conversion material, wherein
- the melting point of metal A is higher than metal B and metal B is chemically reactive towards metal A at their common interface when subject to heating above the melting point of metal B forming an intermetallic compound by solid-liquid interdiffusion.

Alternatively, the first and second bonding layers of metal A and B, respectively, may advantageously also be deposited inside the same vapour deposition chamber as the ADA-structure by simply changing to precursor gas(es) forming the first and/or then the second bonding layer. That is, both the adhesion layer /diffusion barrier layer/adhesion layer structure (the ADA-structure) and the solid-liquid interdiffusion bonding layers may be formed in a chemical vapour deposition chamber, a physical deposition chamber, or an atomic deposition chamber, where the deposition of the different layers is obtained by feeding pre-cursor gases with varying chemical composition into the deposition chamber. Alternatively, the element of semiconducting thermoelectric conversion material may be taken out of the vapour deposition chamber after formation of the ADA-structure and then deposit the first and second bonding layers with electroplating or electro-less plating.

In a second aspect, the present invention relates to a thermoelectric device, comprising:

- a number of N thermoelectric elements of semiconducting thermoelectric conversion material doped to n-type conductivity and a number of N thermoelectric elements of semiconducting thermoelectric conversion material doped to p-type conductivity, where N is an integer from 1 to n,
- a number of 2N+1 electric contact elements comprising a first bonding layer of a metal A and a second bonding layer of a metal B, and
- a first substrate in thermal contact with a heat reservoir and second substrate in thermal contact with a heat sink,

where

- the N thermoelectric elements of n-type conductivity and the N thermoelectric elements of p-type conductivity are electrically connected in series by the 2N+1 electric contact elements,
- the thermoelectric elements are bonded to the electric contact elements by solid liquid interdiffusion bonds, and
- the thermoelectric elements are on a first side in thermal contact with the first substrate in thermal contact with a heat reservoir, and on a second side opposite the first side, the thermoelectric elements are on a second side opposite the first side in thermal contact with the second substrate in thermal contact with a heat sink, wherein
- each of the N thermoelectric elements of n-type conductivity and the N thermoelectric elements of p-type conductivity have on their first and second surface:

    i) a first adhesion layer of a first metal deposited directly onto the first and second surfaces,
    ii) a diffusion barrier layer of a non-metallic compound of a second metal deposited directly onto the first adhesion layer on the first and second surfaces,
    iii) a second adhesion layer of a third metal deposited directly onto the diffusion barrier layer of the non-metallic compound of the second metal on the first and second surfaces,
    iv) a first bonding layer of a metal A deposited directly onto the second adhesion layer on the first and second surfaces, and
    v) a second bonding layer of a metal B deposited directly onto the first bonding layer the on the first and second surfaces,

    where

    - the non-metallic compound of the second metal is either a nitride or an oxide of the second metal,
    - the melting point of metal A is higher than metal B and metal B is chemically reactive towards metal A at their common interface when subject to heating above the melting point of metal B, and
    - the solid liquid interdiffusion bonds have been formed by laying the second bonding layer of metal B of the thermoelectric elements and the electric contact elements, respectively, facing and contacting each other followed by an annealing which causes metal B of the second bonding layer to melt and reacting with metal A of the first bonding layer.

The term "metallization, interconnection and bonding" as used herein means the formation of the mechanical, thermal and electric contacts in a thermoelectric device necessary for collecting and conducting the electric energy produced in the thermoelectric device.

The term "metal" as used in the first and second aspect of the invention is to be interpreted as metal in the generic sense of the term such that it encompasses elementary metal as well as alloys of the same metal. Thus, for example, if the metal in one example embodiment is Ni, the term may be interpreted to be elementary Ni or a Ni-alloy such as i.e. nickel vanadium alloy, nickel silver alloy or other nickel alloys.

The term "pre-processed semiconducting thermoelectric conversion material for metallization, interconnection and bonding" as used herein, means any element of semiconducting thermoelectric material intended to be electrically connected with other elements of semiconducting thermoelectric materials to form a thermoelectric device (interchangeably also termed as: TE-device), and which has been processed such that it is ready to be electrically connected with the other (which are similarly pre-processed) elements of semiconducting thermoelectric material of the TE-device by solid-liquid interdiffusion bonding (interchangeably also termed as: SLID-bonding). The pre-processing of the element of semiconducting thermoelectric material according to the present invention comprises at least depositing on areas on the element where a SLID-bonding is to be formed, in successive order; a first adhesion layer ensuring adequate mechanical bonding to the semiconducting material, a diffusion barrier layer to prevent detrimental interdiffusion of elements between the semiconducting material and the electrode material, a second adhesion layer to obtain sufficient bonding to the diffusion barrier layer, and then a first and second metal layer which are to form the SLID-bond with corresponding layers on the electrode.

The term "element of semiconducting thermoelectric conversion material (interchangeably also termed as: TE-element)" as used herein, means any lump, piece or other form of a compact mass of a semiconducting material exhibiting satisfactory ZT-values for being used in thermoelectric devices when doped to p-type or n-type conductivity. The first and second surfaces on opposite sides of the TE-element may advantageously be substantially parallel and planar surfaces on two opposite ends of the element to alleviate use of the SLID-bonding for interconnection of two or more TE-elements into a TE-device having the structures as illustrated in figures 2 a) and 2 b). However, the feature of substantially parallel and planar opposite surfaces of the TE-element is not mandatory, nor is the terms parallel and planar to be interpreted in the mathematical sense of the terms. The invention, i.e. the use of a first adhesion layer, followed by a diffusion barrier layer and then a second adhesion layer in combination with a SLID-bonding (interchangeably also termed as; the ADA/SLID-structure) may apply TE-elements having slightly inclined surfaces and surfaces with certain degree of irregular surface roughness as long as it is practically feasible to compensate for these "defects" by using a thicker and/or having an uneven thickness of the first adhesion layer and/or other layer in the ADA/SLID-structure. The term "substantially planar and parallel" is thus to be interpreted in this context, and each TE-element which is to be applied in the first and/or second aspect of the invention may advantageously have substantially the same geometry and dimensions with substantially planar and parallel first and second surfaces where the first adhesion layer is to be deposited. The term "substantially same geometry and dimensions" as used herein means that each TE-element has almost the same design as the other TE-elements applied in the TE-device within a reasonable variation such that the vertical distance between the first and second surface is the same for each TE-element within a few percent variation allowing placing the TE-elements side by side and obtaining a satisfactory SLID-bonding with the electric contact elements to form a TE-device with a similar structure and design as the TE-device illustrated in figures 2 a) and 2 b).

Many semiconducting thermoelectric conversion materials may leach elements by solid interdiffusion etc. which are detrimental to the thermal and electric properties of the interconnection electrodes (the electric contact elements), such that it should be employed an intermediate diffusion barrier layer between the semiconducting thermoelectric conversion material and the electric contact elements to protect the electrodes. Thus, the invention according to the first and second aspect may advantageously comprise a thin layer of a thickness from 100 nm and above of a metal oxide or a metal nitride is often an excellent diffusion barrier. Examples of preferred diffusion barriers include, but are not limited to 100 - 1000 nm thick layers of $CrN_x$, $TaN_x$, or $TiN_x$ formed by vapour deposition. The thickness of the diffusion barrier layer may advantageously be in one of the following ranges: from, 50 to 5000 nm, from 75 to 3000 nm, from 100 to 2000 nm, from 150 to 1000 nm, from 150 to 750 nm, from 200 to 500 nm, from 200 to 400 nm or from 200 to 300 nm.

The adherence between the diffusion barrier layer and the semiconducting thermoelectric conversion material has sometimes proven to be insufficient to withstand the shear stresses arising form the thermal expansion involved in thermoelectric devices which may lead to an electrically disconnection between the TED-element and its electrode. It is thus common to increase the adherence between the TED-element and the electrode by applying an intermediate adhesion layer. The invention according to the first and second aspect should thus comprise a first adhesion layer which is deployed directly onto the first and second surface of each TED-element that is to be employed in the TE-device and which forms an intermediate layer between the TE-element and the diffusion barrier layer. Many metals are known to adhere well to both semiconducting materials and typical diffusion barriers and may thus be for being applied as the first adhesion layer. For instance, when the diffusion barrier layer is a metal nitride or metal oxide, any metal known to a person skilled in the art to form excellent bonding with semiconducting materials and metal oxides or metal nitrides may be applied by the first and second aspects of the present invention. The thickness of the first adhesion layer may advantageously be in one of the following ranges; from 20 nm to 2 $\mu$m, from 50 nm to 1.5 $\mu$m, from 100 nm to 1.5 $\mu$m, from 200 nm to 1.5 $\mu$m, or from 500 nm to 1.5 $\mu$m. The actual choice of which metal to be applied as the first adhesion layer is usually dependent upon which materials are being applied in the semiconducting thermoelectric conversion material and in the diffusion barrier layer. However, a person skilled is able to make this selection from her/his general knowledge. Examples of suited metals for use as adhesion layers includes, but is not confined to; Cr, Cu, Sn, Ta, and Ti.

The adherence between the diffusion barrier layer and the first bonding layer of the metal system of the SLID-bonding has also proven to be possibly problematic due to insufficient resilience towards thermally induced shear stresses. It is thus suggested by the present invention according to the first and second aspect to apply a second adhesion layer in-between the diffusion barrier layer and the first bonding layer. The second adhesion layer may as the first adhesion layer, be a metal layer but not necessarily of the same metal as the first adhesion layer. As far as the inventor knows, the use of a second adhesion layer is not known in the prior art. The thickness of the second adhesion layer may be in one of the following ranges; from 20 nm to 1000 nm, from 30 nm to 750 nm, from 40 nm to 500 nm, from 100 nm to 400 nm, or from 150 nm to 300 nm. The actual choice of which metal to be applied as the second adherence layer is usually dependent upon which materials are being applied diffusion barrier layer and in the first bonding layer. A person skilled is able to make this selection from her/his general knowledge.

However, a substantial simplifying and work load saving in the production process may be obtained by choosing the same metal in both the first and second adhesion layers as the metal of the metal oxide or metal nitride of the diffusion barrier layer. In this case the ADA-structure is made up of one single metal in elementary form and as an oxide or nitride, such that the entire ADA-structure may be deposited in one single vapour deposition process by simply changing the composition of the pre-cursor gases being fed into the deposition chamber. Thus, if the diffusion barrier layer is made of one of the preferred layers of CrN, TaN, or TiN, both the first and second adhesion layers may advantageously be made of elementary Cr, Ta, or Ti, respectively.

The term "solid-liquid interdiffusion bonding" or "SLID-Bonding" as used herein, is a high temperature technique for interconnection of two metal phases by use of an intermediate metal phase and annealing such as described in i.e. Bader et al. 1994 [1]. The interconnection (bonding) is obtained by employing an intermediate metal phase which in the liquid phase is chemically reactive against the two outer metal phases forming solid intermetallic compounds, and which has a lower melting point than the two metal outer phases that are to be interconnected. SLID-bonding is also denoted as transient liquid phase bonding, isothermal solidification or off-eutectic bonding in the literature. Examples of suited metal systems for SLID-bonding comprise Au-In, Au-Sn, Ag-In, Ag-Sn, Cu-Sn, and Ni-Sn. In principle, any thickness of the layers of the metal system may be applied in a SLID-bonding. This also applies to the method according to the first and second aspect of the invention. However, in practice, it is advantageous that the initial thickness of the first bonding layer of metal A is in one of the following ranges; from 1 $\mu$m to 1 cm, from 1 $\mu$m to 0.5 cm, from 1 $\mu$m to 0.1 cm, from 2 $\mu$m to 500 $\mu$m, from 2 $\mu$m to 100 $\mu$m, from 2 $\mu$m to 50 $\mu$m, or from 3 $\mu$m to 10 $\mu$m. And the initial thickness of the second bonding layer of metal B may advantageously be in one of the following ranges; from 300 nm to 0.75 cm, 300 nm to 0.3 cm, 300 nm to 750 $\mu$m, from 200 nm to 400 $\mu$m, from 200 nm to 75 $\mu$m, from 200 nm to 30 $\mu$m, or from 300 nm to 3 $\mu$m. The term "initial thickness" of the bonding first and/or second binding layer is the thickness of the respective bonding layer before annealing and formation of the intermetallic compound(s). Both the chemical structure and physical dimensions of the resulting SLID-bond layers are somewhat changed as compared to the initial (non-reacted) bonding layers involved in the SLID-bonding.

The electric contact elements that are to be applied for electrically connecting the TE-elements into a TE-device should be a stratified layered element comprising two metal layers of the same metals as the stratified metal layers of the first and second bonding layer respectively. That is, the electric contact element comprises a first bonding layer of metal A and a second bonding layer of metal B. The thickness of the second metal layer of the electric contact element may advantageously be the same as the thickness of the second boundary layer deposited on the TE-element; however this is not mandatory, other thicknesses may be applied if convenient. The same applies for the first boundary layer of the electric contact element, this may have the same thickness as the first boundary layer of the TE-element, but this is not mandatory, other thicknesses may be applied. It might i.e. be found advantageous to apply a thicker first boundary layer of the electric contact element to obtain mechanical strength. Thus any thickness within reasonable practical limits may be applied as the first boundary layer of the electric contact element.

The principle of forming a SLID-bonding is illustrated schematically in figures 3 a) to c). In figure a) there are illustrated two elements of a two-layered metal system consisting of metal A and metal B. The upper element in figure 3 a) may i.e. be the first and second bonding layer of a TE-element according to the first and second aspect of the invention and the lower element may be the first and second bonding layer of an electric contact element, or vice versa. In figure 3 b) the two elements are contacted such that the second bonding layers of metal B of both elements are facing each other. In figure 3 c), the two elements have been subject to an annealing process which has made the metals to react and form an intermediate solid intermetallic phase A-B which securely and firmly bonds the remaining part of the first bonding layer of both the TE-element and the electric contact element together into one solid object defined by all three layers. It is known to form the SLID-bond by using several alternating metal layers of metals A and B instead of the two-layer metal system discussed above. This alternative embodiment of the SLID-bonding may be applied by the invention according to the first and second aspect if convenient. The metal A in the figures 3 a) to c) corresponds to the metal of the first bonding layer and the metal B corresponds to the metal of the second bonding layer of either the TE-element or the electric contact element. Metal A has thus the highest melting point and may i.e. be one of; Au, Ag, Cu, Ni or other metals. Metal B is having the lower melting point and may i.e. be one of; In, Sn or other metals. The choice of which metal system to be applied in the SLID-bonding may advantageously take into consideration the thermal expansion of other components in the TE-device, especially the thermal expansion of the TE-element.

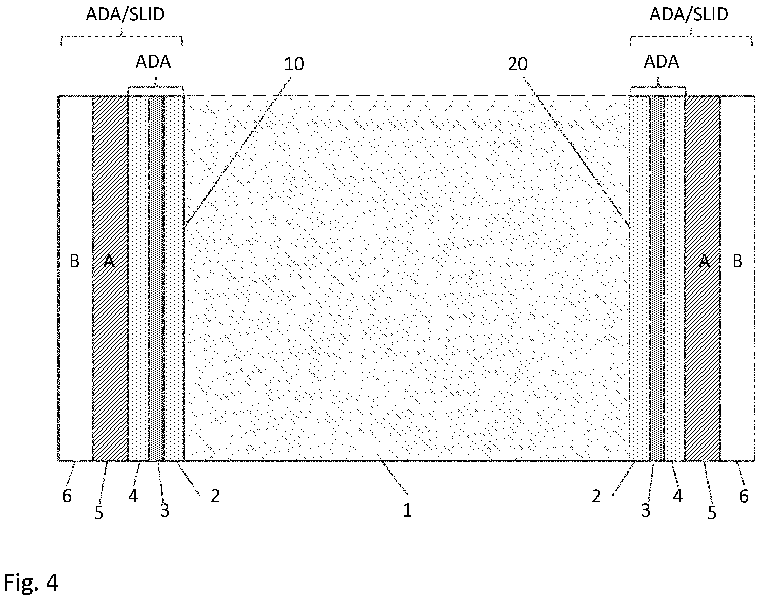

The method according to the first aspect of the invention produces one TE-element, of either p-type conductivity or n-type conductivity, having the structure schematically illustrated in figure 4. On the figure an element made of a semiconducting thermoelectric conversion material 1 having a first surface 10 opposite to a second surface 20 is shown. On both the first 10 and second 20 surfaces there are deposited a first adhesion layer 2 of a first metal, followed by a diffusion barrier layer 3 of a non-metallic compound of a second metal, and then a second adhesion layer 4 of a third metal. All layers are deposited directly onto each other such that they are in direct contact with its respective neighbouring layer. The first adhesion layer, the diffusion barrier layer and the second adhesion layer constitutes the ADA-structure, as shown with the parenthesis on the figure marked ADA. Then follows the first bonding layer 5 of metal A and the second bonding layer 6 of metal B which are defining the "element part" of the metals system that is to be formed into the SLID-bond. These layers forms together with the ADA-structure the ADA/SLID-structure as shown by the parenthesis marked ADA/SLID on the figure. For the purpose of illustration, the dimensions in the figures are not shown to scale.

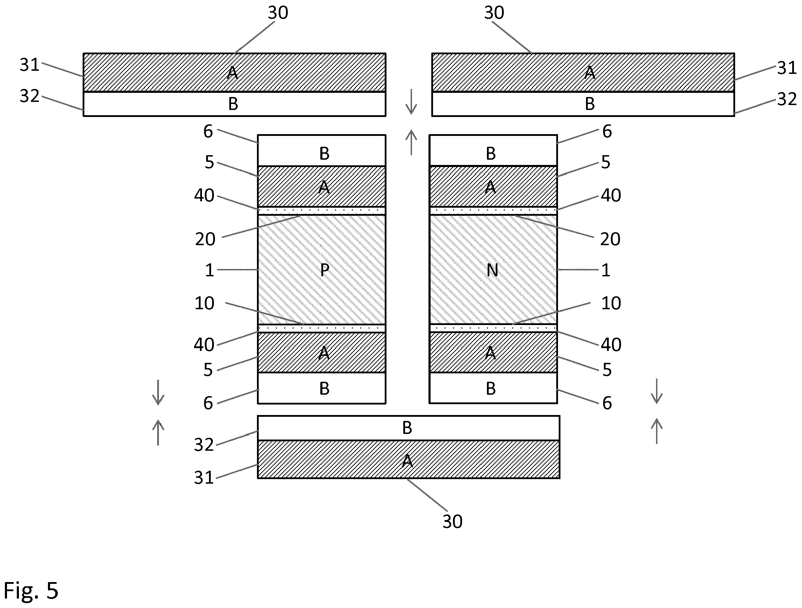

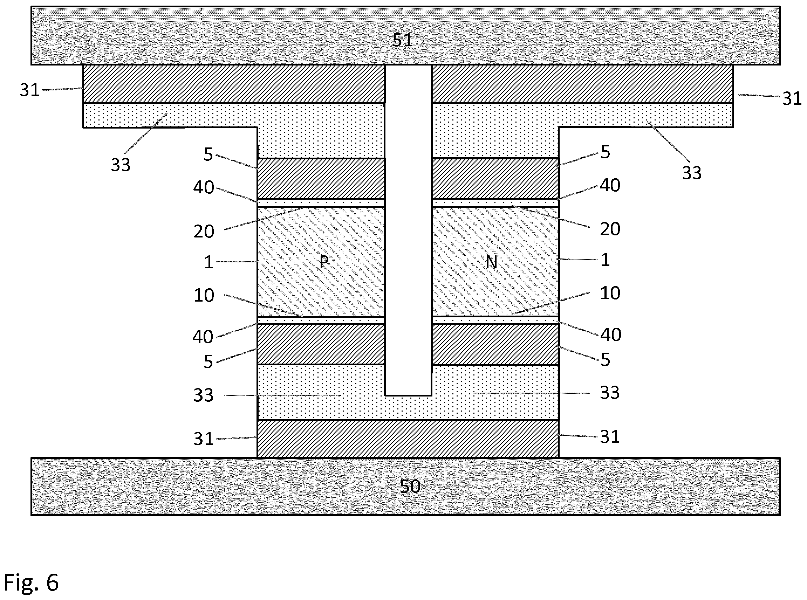

In figure 5 the principle solution of how to assemble the TE-elements and electric contact elements before the annealing process for forming the SLID-bonds is illustrated by way of two TE-elements 1, one doped to p-type conductivity and the other doped to n-type conductivity, and three electric contact elements 30. Each TE-element 1 has been provided with the same layers defining the ADA/SLID-structure on its first and second surface as shown in more detail in figure 3. In figure 4, the ADA-structure, i.e. the first adhesion layer 2, the diffusion barrier layer 3 and the second adhesion layer 4, is however illustrated as a single thin layer 40 for the sake of illustrative clarity. On each ADA-structure on both the first 10 and the second 20 side of each TE-element 1, there is deposited a first 5 and a second 6 bonding layer which constitutes the TE-element side of the electric interconnections that are to be formed. The electric contact element which comprises the stratified layered metal structure of a first bonding layer 31 of metal A and a second bonding layer 32 of metal B constitutes the electric contact side of the electric interconnections that are to be formed. By pressing these elements 1, 30 together as indicated by the arrows and annealing the entire structure to a temperature where metal B melts and forms one or more solid intermetallic compounds with metal A, the two TE-elements 1 and the three electric contact elements become both electrically connected in series and firmly bonded into a single solid unit by the SLID-bonds formed by the first and second contact layers on the TE-elements and the electric contact elements. Then by adding a first substrate in thermal contact with a heat reservoir and a second substrate in thermal contact with a heat sink onto the outer side (the opposite side of the side facing the TE-elements) of the formed interconnections, a TE-device having a similar structure as shown in i.e. figures 2 a) or b) is formed. The TE-device resulting from the assembly shown in figure 5 is schematically illustrated in figure 6. Here reference number 33 relates to the solid intermetallic(s) AB, reference number 50 relates to the first substrate in thermal contact with a heat reservoir, and reference number 51 relates to the second substrate in thermal contact with a heat sink.

The ADA/SLID-structure provides a very strong and resilient bonding between the electric contact elements and the TE-elements of the TE-device, and is thus especially suited for use in high-temperature appliances which involve relatively strong shear stresses at the bonding interfaces due to differences in the thermal expansions of the materials of the different layers, TE-element and electrode. Even though, the present invention may use any semiconducting thermoelectric conversion material, it is preferred to employ filled or non-filled $CoSb_3$-based skutterudite thermoelectric conversion materials due to their promising figure of merit, ZT, at temperatures up to about 800 °C. It is advantageous to employ a metal system with a thermal expansion as equal as the TE-element as possible. Thus, in the case of employing TE-elements of filled or non-filled $CoSb_3$-based skutterudite thermoelectric conversion materials, it is preferred to employ the metal system Ni - Sn for the SLID-bonding.

**List of figures**

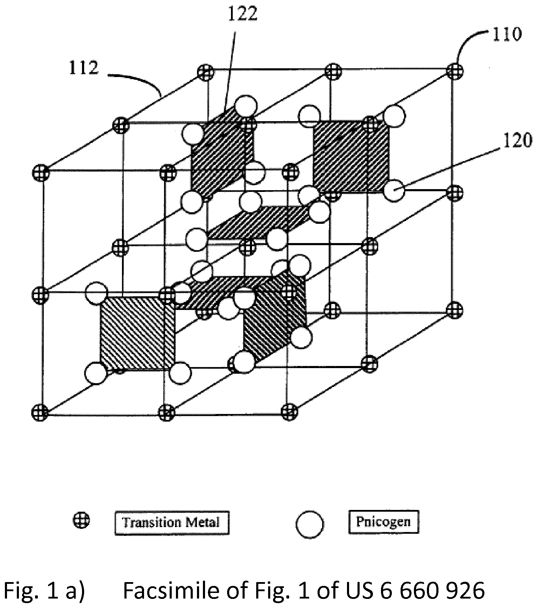

Figure 1 is a facsimile of Fig. 1 of US 6 660 926 showing a schematic representation of the crystal structure of the mineral skutterudite.

Figure 2 a) is a schematic side view illustrating the structure of a thermoelectric device involving one P-doped and one N-doped element of thermoelectric conversion material.

Figure 2 b) is a copy of Fig. 18 of US 6 660 926 (without text on the figure) showing a similar TE-device as shown in figure 2 a) involving several P-doped and one N-doped elements of thermoelectric conversion materials electrically connected in series.

Figures 3a to 3c are schematic side views illustrating the principle of forming a SLID-bond.

Figure 4 is a schematic side view illustrating the ADA/SLID-structure on TE-elements according to the invention.

Figure 5 is a schematic side view illustrating the assembly of one P-doped and on N-doped TE-element having the ADA/SLID-structure according to the invention for interconnecting them is series by SLID-bonding to three electric contact elements.

Figure 6 is a schematic side view illustrating the structure of the a TE-device resulting from formation of the SLID-bonds and attachment of the substrates in contact with the thermal reservoir and thermal sink, respectively, of the assembly shown in figure 5.

**Example embodiment of the invention**

The invention is described in more detail by way of example embodiments of a thermoelectric device with a similar construction as illustrated in figures.

.underline[First example embodiment]

The first example embodiment utilises a filled or non-filled $CoSb_3$-based skutterudite as the semiconducting thermoelectric conversion material intended to operate at high temperatures, i.e. at temperatures in the range from about 0 °C to about 800 °C.

Thus in the first example embodiment of the invention according to the first aspect, the invention is a method for forming a pre-processed semiconducting thermoelectric conversion material for metallization, interconnection and bonding, wherein the method comprises the following process steps in successive order:

-    employing at least one element of a n-type or p-type doped semiconducting thermoelectric conversion material of a filled or non-filled $CoSb_3$-based skutterudite having a first and second surface on opposite sides,
- placing the at least one element of semiconducting thermoelectric conversion material into a deposition chamber, and then:

    i) depositing a first adhesion layer of a first metal directly onto the first and the second surface of the element of the semiconducting thermoelectric conversion material,
    ii) depositing a diffusion barrier layer of a non-metallic compound of a second metal directly onto the first adhesion layer on the first and second surface of the semiconducting thermoelectric conversion material element,
    iii) depositing a second adhesion layer of a third metal directly onto the diffusion barrier layer of the non-metallic compound of the second metal on the first and second surface of the element of the semiconducting thermoelectric conversion material,
    iv) depositing a first bonding layer of a metal A directly onto the second adhesion layer on the first and second surface of element of the semiconducting thermoelectric conversion material, and
    v) depositing a second bonding layer of a metal B directly onto the first bonding layer the on the first and second surface of the element of the semiconducting thermoelectric conversion material,

wherein

- the deposition chamber is either a chemical vapour deposition chamber, a physical deposition chamber, or an atomic deposition chamber, and the deposition of the different layers of steps i) to v) is obtained by feeding pre-cursor gases with varying chemical composition into the deposition chamber,
- the non-metallic compound of the second metal is either a nitride or an oxide of the second metal, and
- the melting point of metal A is higher than metal B and metal B is chemically reactive towards metal A at their common interface when subject to heating above the melting point of metal B forming an intermetallic compound by solid-liquid interdiffusion.

The first example embodiment also includes a thermo electric device utilising a filled or non-filled $CoSb_3$-based skutterudite as the semiconducting thermoelectric conversion material. Thus, the example embodiment of the invention also comprises a thermoelectric device, comprising:

- a number of N thermoelectric elements of semiconducting thermoelectric conversion material of a filled or non-filled $CoSb_3$-based skutterudite doped to n-type conductivity and a number of N thermoelectric elements of semiconducting thermoelectric conversion material of a filled or non-filled $CoSb_3$-based skutterudite doped to p-type conductivity, where N is an integer from 1 to n,
- a number of 2N+1 electric contact elements comprising a first bonding layer of a metal A and a second bonding layer of a metal B, and
- a first substrate in thermal contact with a heat reservoir and second substrate in thermal contact with a heat sink,

where

- the N thermoelectric elements of n-type conductivity and the N thermoelectric elements of p-type conductivity are electrically connected in series by the 2N+1 electric contact elements,
- the thermoelectric elements are bonded to the electric contact elements by solid liquid interdiffusion bonds, and
- the thermoelectric elements are on a first side in thermal contact with the first substrate in thermal contact with a heat reservoir, and on a second side opposite the first side, are second substrate in thermal contact with a heat sink, wherein
- each of the N thermoelectric elements of n-type conductivity and the N thermoelectric elements of p-type conductivity have on their first and second surface:

    i) a first adhesion layer of a first metal deposited directly onto the first and second surfaces,
    ii) a diffusion barrier layer of a non-metallic compound of a second metal deposited directly onto the first adhesion layer on the first and second surfaces,
    iii) a second adhesion layer of a third metal deposited directly onto the diffusion barrier layer of the non-metallic compound of the second metal on the first and second surfaces,
    iv) a first bonding layer of a metal A deposited directly onto the second adhesion layer on the first and second surfaces, and
    v) a second bonding layer of a metal B deposited directly onto the first bonding layer the on the first and second surfaces,

where

- the non-metallic compound of the second metal is either a nitride or an oxide of the second metal,
- the melting point of metal A is higher than metal B and metal B is chemically reactive towards metal A at their common interface when subject to heating above the melting point of metal B, and
- the solid liquid interdiffusion bonds are formed by laying the second bonding layer of metal B of the thermoelectric elements and the electric contact elements, respectively, facing and contacting each other followed by an annealing which causes metal B of the second bonding layer to melt and reacting with metal A of the first bonding layer.

Every layer of the ADA/SLID-structure of the first example embodiment may have the same thicknesses as given above in section "Description of the invention". Also, in an especially preferred alternative of the example embodiment, the first metal of the first adhesion layer and the third metal of second adhesion layer is the same metal, and may be one of Cr, Ta or Ti. Further, the non-metallic compound of the second metal of the diffusion barrier layer is in this example embodiment a nitride of the same metal as employed in the adhesion layers, i.e. one of CrN, TaN or TiN, respectively. And further, the metal A of the first bonding layer is one of Au, Ag, Cu, Ni, a Ni-V alloy with from 6.5 to 7.5 atomic% V, and metal B is one of; In or Sn.

In a more preferred alternative of the first example embodiment, the first and second adhesion layers is a layer of at least 99.5 weight% pure Ti, the diffusion barrier layer is TiN, the metal A of the first bonding layer of both the TE-element and the electric contact element is Ni, and the metal B of the second bonding layer of both the TE-element and the electric contact element is Sn.

The combination of employing an adhesion layer of pure Ti having a more than 99.5 % purity based on the total weight of the Ti-phase, a diffusion barrier layer of TiN and a contact layer of Ni has proven to provide an especially robust metallisation exhibiting excellent electric and thermal conductivities of $CoSb_3$-based skutterudite thermoelectric conversion materials, which may easily and securely be bonded to the electrodes of the thermoelectric device by use of the SLID-technology. That is, the electrode may be bonded to the $CoSb_3$-based skutterudite thermoelectric conversion material by depositing a contact layer of Ni and then a bonding layer of Sn on the electrode, and then bonding them together by pressing the bonding layers of Sn together and heating them until the Sn reacts with the Ni and forms one or more of the following intermetallic compounds; $Ni_3Sn$, $Ni_3Sn_2$, or $Ni_3Sn_4$.

The inventor has discovered that the bonding strength and the electric and thermal conductivity of the layers forming the metallisation structure may be significantly improved by practically avoiding any oxidation of the metal phases (Ti, Ni or Sn) during and after deposition. That is, the deposition process should advantageously be performed in a protected atmosphere practically void of oxygen (i.e. having less than 50 ppm oxygen) or made under a vacuum (i.e. at a pressure of less than 1000 Pa). Alternatively, if the handling of the thermoelectric material after formation of the metallisation involves exposure to air/oxygen, the metallic surfaces deposition proves may include depositing 10 to 50 nm of Au on top of the metal layer as an oxidation resistance layer.

The oxidation resistance layer may be applied onto either the Ti layer (the adhesion layer), the contact layer (Ni) or the bonding layer (Sn), or one two or more of these.

Second example embodiment

The thermoelectric elements of the second example embodiment are formed by depositing a Ti layer having a thickness of approximately 200 nm, a TiN layer having a thickness of approximately 1000 nm and a Ni layer having a thickness of approximately 1000 nm on p- and n-type thermoelectric elements (doped $CoSb_3$) with a size of 4.5 x 4.5 x 3.5 $mm^3$. The adhesion between the TE material and the metallization was then quantified by pull-testing before and after thermal aging. The pull-strength was above 20 MPa both for reference samples and thermally aged samples, and the fractures were cohesive TE material fractures (i.e. inside the bulk of the TE material), meaning that the adhesion strength between the TE material and the metallization is higher than the tensile bulk strength of the TE material.

Third example embodiment

The thermoelectric module of the third example embodiment is formed by depositing a Ti layer having a thickness of approximately 200 nm, a TiN layer having a thickness of approximately 1000 nm and a Ni layer having a thickness of approximately 2000 nm on p- and n-type thermoelectric elements (doped $CoSb_3$) with a size of 4.5 x 4.5 x 3.5 $mm^3$. Furthermore, a Cu layer with a thickness of approximately 20 $\mu$m, a Ni layer with a thickness of approximately 5 $\mu$m and a Sn layer with a thickness of approximately 2 $\mu$m is deposited on an alumina substrate. The functionalized TE elements are then placed on the substrate, and a thermos-compression bonding is performed in an inert atmosphere. The bonding is performed with a pressure of 2 MPa at 300 °C for 20 minutes forming a Ni-Sn SLID bond. The Ni-Sn SLID bond consist of pure Ni and $Ni_3Sn_4$, where the latter has a melting point close to 800 °C, giving and high operating temperature. The bond also has high mechanical strength. Shear strength tests show that the bond strength is above 60 MPa, well above other known techniques stating bond strengths of approximately 10 MPa.

**References**

**1** Bader et al. (1994), "RAPID FORMATION OF INTERMETALLIC COMPOUNDS BY INTERDIFFUSION IN THE Cu-Sn AND Ni-Sn SYSTEMS", Acta metall, mater. Vol. 43, No. 1, pp. 329-337, 1995

## Claims

1. A method for forming a pre-processed semiconducting thermoelectric conversion material (1) for metallization, interconnection and bonding, wherein the method comprises the following process steps in successive order:

   - employing at least one element of a n-type or p-type doped semiconducting thermoelectric conversion material having a first and second surface on opposite sides,
   - placing the at least one element of semiconducting thermoelectric conversion material into a deposition chamber, and then:

      i) depositing a first adhesion layer (2) of a first metal directly onto the first and the second surface of the element of the semiconducting thermoelectric conversion material,
      ii) depositing a diffusion barrier layer (3) of a non-metallic compound of a second metal directly onto the first adhesion layer on the first and second surface of the semiconducting thermoelectric conversion material element,
      iii) depositing a second adhesion layer (4) of a third metal directly onto the diffusion barrier layer of the non-metallic compound of the second metal on the first and second surface of the element of the semiconducting thermoelectric conversion material,

   wherein

      - the deposition chamber is either a chemical vapour deposition chamber, a physical vapour deposition chamber, or an atomic deposition chamber, and the deposition of the different layers of steps i) to iii) is obtained by feeding pre-cursor gases with varying chemical composition into the deposition chamber,
      - the non-metallic compound of the second metal is either a nitride or an oxide of the second metal,

   - depositing a first bonding layer (5) of a metal A directly onto the second adhesion layer on the first and second surface of element of the semiconducting thermoelectric conversion material, and
   - depositing a second bonding layer (6) of a metal B directly onto the first bonding layer the on the first and second surface of the element of the semiconducting thermoelectric conversion material, wherein

   - the melting point of metal A is higher than metal B and metal B is chemically reactive towards metal A at their common interface when subject to heating above the melting point of metal B forming an intermetallic compound by solid-liquid interdiffusion.

2. A method according to claim 1, wherein the semiconducting thermoelectric conversion material is a filled or non-filled $CoSb_3$-based skutterudite.

3. A method according to any of claims 1-2, wherein the first metal of the first adhesion layer and the second metal of the second adhesion layer is of the same elementary metal, and where the non-metallic compound of the second metal of the diffusion barrier layer is a nitride or an oxide of the same elementary metal as the first and second metal.

4. A method according to claim 3, wherein the elementary metal of the first metal of the first adhesion layer and the second metal of the second adhesion layer is one of Cr, Cu, Sn, Ta, and Ti, and the non-metallic compound of the second metal of the diffusion barrier layer is a nitride or an oxide of one of Cr, Cu, Sn, Ta, and Ti.

5. A method according to any of claims 1-4, wherein the metal A of the first bonding layer is one of the following elementary metals; Au, Ag, Cu, Ni, Ni-V alloy with from 6.5 to 7.5 atom% V, and the metal B of the second bonding layer is one of the following elementary metals; In or Sn.

6. A method according to any of claims 1-5, wherein the first and second metal is Ti of at least 99.5 weight% purity, the non-metallic compound of the second metal of the diffusion barrier layer is TiN, the metal A of the first bonding layer is Ni and the metal B of the second bonding layer is Sn.

7. A method according to any of claims 1-6, wherein:

   - the thickness of the first adhesion layer is in one of the following ranges; from 20 nm to 2 $\mu$m, from 50 nm to 1.5 $\mu$m, from 100 nm to 1.5 $\mu$m, from 200 nm to 1.5 $\mu$m, or from 500 nm to 1.5 $\mu$m,
   - the thickness of the diffusion barrier layer is in one of the following ranges: from, 50 to 5000 nm, from 75 to 3000 nm, from 100 to 2000 nm, from 150 to 1000 nm, from 150 to 750 nm, from 200 to 500 nm, from 200 to 400 nm or from 200 to 300 nm,
   - the thickness of the second adhesion layer is in one of the following ranges; from 20 nm to 1000 nm, from 30 nm to 750 nm, from 40 nm to 500 nm, from 100 nm to 400 nm, or from 150 nm to 300 nm,
- the thickness of the first bonding layer of metal A is in one of the following ranges; from 1 $\mu$m to 1 cm, from 1 $\mu$m to 0.5 cm, from 1 $\mu$m to 0.1 cm, from 2 $\mu$m to 500 $\mu$m, from 2 $\mu$m to 100 $\mu$m, from 2 $\mu$m to 50 $\mu$m, or from 3 $\mu$m to 10 $\mu$m, and
- the thickness of the second bonding layer of metal B is in one of the following ranges; from 300 nm to 0.75 cm, 300 nm to 0.3 cm, 300 nm to 750 $\mu$m, from 200 nm to 400 $\mu$m, from 200 nm to 75 $\mu$m, from 200 nm to 30 $\mu$m, or from 300 nm to 3 $\mu$m.

8. A method according to any of claims 1-7, wherein the method further comprises depositing a 10 to 50 nm thick layer of Au directly onto one of the first adhesion layer, the second adhesion layer, or the first bonding layer, or two or more of these.

9. A method according to any of claims 1-8, wherein the first and second bonding layers of metal A and B, respectively, is deposited by:

- depositing by vapour deposition the first bonding layer of a metal A directly onto the second adhesion layer on the first and second surface of element of the semiconducting thermoelectric conversion material and the second bonding layer of a metal B directly onto the first bonding layer the on the first and second surface of the element of the semiconducting thermoelectric conversion material in the same vapour deposition chamber applied for deposition of the first adhesion layer, the diffusion barrier layer and the second adhesion layer structure,

or by:

- depositing the first and second bonding layers by electroplating or by electro-less plating.

10. A thermoelectric device, comprising:

- a number of N thermoelectric elements (1) of semiconducting thermoelectric conversion material doped to n-type conductivity and a number of N thermoelectric elements (1) of semiconducting thermoelectric conversion material doped to p-type conductivity, where N is an integer from 1 to n,
- a number of 2N+1 electric contact elements (30) comprising a first bonding layer (31) of a metal A and a second bonding layer (32) of a metal B, and
- a first substrate (50) in thermal contact with a heat reservoir and second substrate (51) in thermal contact with a heat sink,

where

- the N thermoelectric elements of n-type conductivity and the N thermoelectric elements of p-type conductivity are electrically connected in series by the 2N+1 electric contact elements,
- the thermoelectric elements are bonded to the electric contact elements by solid liquid interdiffusion bonds, and
- the thermoelectric elements are on a first side in thermal contact with the first substrate in thermal contact with a heat reservoir, and on a second side opposite the first side, the thermoelectric elements are on a second side opposite the first side in thermal contact with the second substrate in thermal contact with a heat sink, wherein
- each of the N thermoelectric elements of n-type conductivity and the N thermoelectric elements of p-type conductivity have on their first and second surface:

i) a first adhesion layer (2) of a first metal deposited directly onto the first and second surfaces,
ii) a diffusion barrier layer (3) of a non-metallic compound of a second metal deposited directly onto the first adhesion layer on the first and second surfaces,
iii) a second adhesion (4) of a third metal deposited directly onto the diffusion barrier layer of the non-metallic compound of the second metal on the first and second surfaces,
iv) a first bonding layer (5) of a metal A deposited directly onto the second adhesion layer on the first and second surfaces, and
v) a second bonding layer (6) of a metal B deposited directly onto the first bonding layer the on the first and second surfaces,

where
- the non-metallic compound of the second metal is either a nitride or an oxide of the second metal,
- the melting point of metal A is higher than metal B and metal B is chemically reactive towards metal A at their common interface when subject to heating above the melting point of metal B, and
- the solid liquid interdiffusion bonds have been formed by laying the second bonding layer of metal B of the thermoelectric elements and the electric contact elements, respectively, facing and contacting each other followed by an annealing which causes metal B of the second bonding layer to melt and reacting with metal A of the first bonding layer.

**11.** A thermoelectric device according to claim 10, wherein the semiconducting thermoelectric conversion material is a filled or non-filled CoSb$_3$-based skutterudite.

**12.** A thermoelectric device according to any of claims 10 - 11, wherein the first metal of the first adhesion layer and the second metal of the second adhesion layer is of the same elementary metal, and where the non-metallic compound of the second metal of the diffusion barrier layer is a nitride or an oxide of the same elementary metal as the first and second metal.

**13.** A thermoelectric device according to claim 12, wherein the elementary metal of the first metal of the first adhesion layer and the second metal of the second adhesion layer is one of Cr, Cu, Sn, Ta, and Ti, and the non-metallic compound of the second metal of the diffusion barrier layer is a nitride or an oxide of one of Cr, Cu, Sn, Ta, and Ti.

**14.** A thermoelectric device according to any of claims 10 - 13, wherein the metal A of the first bonding layer is one of the following elementary metals; Au, Ag, Cu, Ni, Ni-V alloy with from 6.5 to 7.5 atom% V, and the metal B of the second bonding layer is one of the following elementary metals; In or Sn.

**15.** A thermoelectric device according to any of claims 10 - 14, wherein the first and second metal is Ti of at least 99.5 weight% purity, the non-metallic compound of the second metal of the diffusion barrier layer is TiN, the metal A of the first bonding layer is Ni and the metal B of the second bonding layer is Sn.

**16.** A thermoelectric device according to any of claims 10 - 15, wherein:

- the thickness of the first adhesion layer is in one of the following ranges; from 20 nm to 2 μm, from 50 nm to 1.5 μm, from 100 nm to 1.5 μm, from 200 nm to 1.5 μm, or from 500 nm to 1.5 μm,
- the thickness of the diffusion barrier layer is in one of the following ranges: from, 50 to 5000 nm, from 75 to 3000 nm, from 100 to 2000 nm, from 150 to 1000 nm, from 150 to 750 nm, from 200 to 500 nm, from 200 to 400 nm or from 200 to 300 nm,
- the thickness of the second adhesion layer is in one of the following ranges; from 20 nm to 1000 nm, from 30 nm to 750 nm, from 40 nm to 500 nm, from 100 nm to 400 nm, or from 150 nm to 300 nm,
- the thickness of the first bonding layer of metal A is in one of the following ranges; from 1 μm to 1 cm, from 1 μm to 0.5 cm, from 1 μm to 0.1 cm, from 2 μm to 500 μm, from 2 μm to 100 μm, from 2 μm to 50 μm, or from 3 μm to 10 μm, and
- the thickness of the second bonding layer of metal B is in one of the following ranges; from 300 nm to 0.75 cm, 300 nm to 0.3 cm, 300 nm to 750 μm, from 200 nm to 400 μm, from 200 nm to 75 μm, from 200 nm to 30 μm, or from 300 nm to 3 μm.

**17.** A thermoelectric device according to any of claims 10 - 16, further comprising a 10 to 50 nm thick layer of Au deposited directly onto one of the first adhesion layer, the second adhesion layer, or the first bonding layer, or two or more of these.

**Patentansprüche**

**1.** Verfahren zum Bilden eines vorverarbeiteten halbleitenden thermoelektrischen Umwandlungsmaterials (1) zum Metallisieren, Vernetzen und Binden, wobei das Verfahren die folgenden Prozessschritte in aufeinanderfolgender Reihenfolge umfasst:

- Einsetzen von wenigstens einem Element aus einem n-leitend oder p-leitend dotierten halbleitenden thermoelektrischen Umwandlungsmaterial, das eine erste und eine zweite Fläche auf gegenüberliegenden Seiten aufweist,
- Positionieren des wenigstens einen Elements aus dem halbleitenden thermoelektrischen Umwandlungsmaterial in einer Beschichtungskammer, und danach:

i) Aufbringen einer ersten Adhäsionsschicht (2) eines ersten Metalls direkt auf die erste und die zweite Fläche des Elements aus dem halbleitenden thermoelektrischen Umwandlungsmaterial,
ii) Aufbringen einer Diffusionsbarriereschicht (3) aus einer nichtmetallischen Verbindung eines zweiten Metalls direkt auf die erste Adhäsionsschicht auf die erste und die zweite Fläche des Elements aus dem halbleitenden thermoelektrischen Umwandlungsmaterial,
iii) Aufbringen einer zweiten Adhäsionsschicht (4) aus einem dritten Metall direkt auf die Diffusionsbarriereschicht aus der nichtmetallischen Verbindung des zweiten Metalls auf die erste und die zweite Fläche des Elements aus dem halbleitenden thermoelektrischen Umwandlungsmaterial, wobei

- die Beschichtungskammer entweder eine chemische Dampfbeschichtungskammer, eine physikalische Dampfbeschichtungskammer oder eine Atombeschichtungskammer ist, und wobei das Aufbringen der verschiedenen Schichten der Schritte i) bis iii) durch ein Einspeisen von Vorstufen-Gasen mit variierenden chemischen Zusammensetzungen in die Beschichtungskammer erreicht wird,

- die nichtmetallische Verbindung des zweiten Metalls entweder ein Nitrid oder ein Oxid des zweiten Metalls ist,

- Aufbringen einer ersten Bindungsschicht (5) aus einem Metall A direkt auf die zweite Adhäsionsschicht auf die erste und die zweite Fläche des Elements aus dem halbleitenden thermoelektrischen Umwandlungsmaterial, und

- Aufbringen einer zweiten Bindungsschicht (6) aus einem Metall B direkt auf die erste Bindungsschicht auf die erste und die zweite Fläche des Elements aus dem halbleitenden thermoelektrischen Umwandlungsmaterial, wobei

- der Schmelzpunkt des Metalls A höher ist als der des Metalls B und das Metall B chemisch reaktiv gegenüber dem Metall A an ihrer gemeinsamen Schnittstelle ist, wenn sie einem Erwärmen über den Schmelzpunkt des Metalls B ausgesetzt sind, und sie durch eine Fest-Flüssig-Interdiffusion eine intermetallische Verbindung bilden.

2. Verfahren nach Anspruch 1, wobei das halbleitende thermoelektrische Umwandlungsmaterial ein gefülltes oder nichtgefülltes $CoSb_3$-basiertes Skutterudit ist.

3. Verfahren nach einem der Ansprüche 1-2, wobei das erste Metall der ersten Adhäsionsschicht und das zweite Metall der zweiten Adhäsionsschicht aus demselben elementaren Metall bestehen, und wobei die nichtmetallische Verbindung des zweiten Metalls der Diffusionsbarriereschicht ein Nitrid oder ein Oxid desselben elementaren Metalls ist wie das des ersten und des zweiten Metalls.

4. Verfahren nach Anspruch 3, wobei das elementare Metall des ersten Metalls der ersten Adhäsionsschicht und des zweiten Metalls der zweiten Adhäsionsschicht eines ist von Cr, Cu, Sn, Ta und Ti, und die nichtmetallische Verbindung des zweiten Metalls der Diffusionsbarriereschicht ein Nitrid oder ein Oxid von einem ist von Cr, Cu, Sn, Ta und Ti.

5. Verfahren nach einem der Ansprüche 1-4, wobei das Metall A der ersten Bindungsschicht eines von den folgenden elementaren Metallen ist: Au, Ag, Cu, Ni, Ni-V-Legierung mit von 6,5 bis 7,5 Atom-% V, und das Metall B der zweiten Bindungsschicht eines von den folgenden elementaren Metallen ist: In oder Sn.

6. Verfahren nach einem der Ansprüche 1-5, wobei das erste und das zweite Metall Ti von wenigstens 99,5 Gew.-% Reinheit sind, wobei die nichtmetallische Verbindung des zweiten Metalls der Diffusionsbarriereschicht TiN ist, wobei das Metall A der ersten Bindungsschicht Ni ist und das Metall B der zweiten Bindungsschicht Sn ist.

7. Verfahren nach einem der Ansprüche 1-6, wobei:

- die Dicke der ersten Adhäsionsschicht sich in einem der folgenden Bereiche befindet: von 20 nm bis 2 $\mu$m, von 50 nm bis 1,5 $\mu$m, von 100 nm bis 1,5 $\mu$m, von 200 nm bis 1,5 $\mu$m oder von 500 nm bis 1,5 $\mu$m,

- die Dicke der Diffusionsbarriereschicht sich in einem der folgenden Bereiche befindet: von 50 bis 5000 nm, von 75 bis 3000 nm, von 100 bis 2000 nm, von 150 bis 1000 nm, von 150 bis 750 nm, von 200 bis 500 nm, von 200 bis 400 nm oder von 200 bis 300 nm,

- die Dicke der zweiten Adhäsionsschicht sich in einem der folgenden Bereiche befindet: von 20 nm bis 1000 nm, von 30 nm bis 750 nm, von 40 nm bis 500 nm, von 100 nm bis 400 nm oder von 150 nm bis 300 nm,

- die Dicke der ersten Bindungsschicht aus dem Metall A sich in einem der folgenden Bereiche befindet: von 1 $\mu$m bis 1 cm, von 1 $\mu$m bis 0,5 cm, von 1 $\mu$m bis 0,1 cm, von 2 $\mu$m bis 500 $\mu$m, von 2 $\mu$m bis 100 $\mu$m, von 2 $\mu$m bis 50 $\mu$m oder von 3 $\mu$m bis 10 $\mu$m, und

- die Dicke der zweiten Bindungsschicht aus dem Metall B sich in einem der folgenden Bereiche befindet: von 300 nm bis 0,75 cm, von 300 nm bis 0,3 cm, von 300 nm bis 750 $\mu$m, von 200 nm bis 400 $\mu$m, von 200 nm bis 75 $\mu$m, von 200 nm bis 30 $\mu$m oder von 300 nm bis 3 $\mu$m.

8. Verfahren nach einem der Ansprüche 1-7, wobei das Verfahren ferner ein Aufbringen einer 10 bis 50 nm dicken Schicht von Au direkt auf eines von der ersten Adhäsionsschicht, der zweiten Adhäsionsschicht oder der ersten Bindungsschicht, oder zwei oder mehrere davon umfasst.

9. Verfahren nach einem der Ansprüche 1-8, wobei die erste und die zweite Bindungsschicht aus dem Metall A und dem Metall B jeweils aufgebracht werden durch:

- Aufbringen durch Aufdampfen der ersten Bindungsschicht aus einem Metall A direkt auf die zweite Adhäsionsschicht auf die erste und die zweite Fläche des Elements aus dem halbleitenden thermoelektrischen Umwandlungsmaterial und der zweiten Bindungsschicht aus einem Metall B direkt auf die erste Bindungsschicht auf die erste und zweite Fläche des Elements aus dem halbleitenden thermoelektrischen Umwandlungsmaterial in derselben Dampfbeschichtungskammer, die zum Aufbringen der ersten Adhäsionsschicht, der Diffusionsbarriereschicht und der zweiten Adhäsionsschichtstruktur angewendet wurde,

oder durch:

- Aufbringen der ersten und der zweiten Bindungsschicht durch galvanisches Beschichten oder durch nichtgalvanisches Beschichten.

10. Thermoelektrische Vorrichtung, die Folgendes umfasst:

- eine Anzahl von N thermoelektrischen Elementen (1) aus einem halbleitenden thermoelektrischen Umwandlungsmaterial, das mit n-Leitfähigkeit dotiert ist, und eine Anzahl von N thermoelektrischen Elementen (1) aus einem halbleitenden thermoelektrischen Umwandlungsmaterial, das mit p-Leifähigkeit dotiert ist, wobei N eine ganze Zahl von 1 bis n ist,
- eine Anzahl von 2N+1 elektrischen Kontaktelementen (30), die eine erste Bindungsschicht (31) aus einem Metall A und eine zweite Bindungsschicht (32) aus einem Metall B umfassen, und
- ein erstes Substrat (50), das sich in thermischem Kontakt mit einem Wärmespeicher befindet, und ein zweites Substrat (51), das sich in thermischem Kontakt mit einem Wärmeableiter befindet,

wobei

- die N thermoelektrischen Elemente mit n-Leitfähigkeit und die N thermoelektrischen Elemente mit p-Leitfähigkeit in Reihe elektrisch verbunden sind durch die 2N+1 elektrischen Kontaktelemente,
- die thermoelektrischen Elemente mit den elektrischen Kontaktelementen durch Fest-Flüssig-Interdiffusionsbindungen verbunden sind, und
- die thermoelektrischen Elemente sich auf einer ersten Seite in thermischem Kontakt mit dem ersten Substrat befinden, das sich in thermischem Kontakt mit einem Wärmespeicher befindet, und auf einer zweiten Seite gegenüber der ersten Seite, die thermoelektrischen Elemente sich auf einer zweiten Seite gegenüber der ersten Seite in thermischem Kontakt mit dem zweiten Substrat befinden, das sich in thermischem Kontakt mit einem Wärmeableiter befindet, wobei

- jedes der N thermoelektrischen Elemente mit n-Leitfähigkeit und der N thermoelektrischen Elemente mit p-leitfähigkeit Folgendes auf seiner ersten und seiner zweiten Fläche aufweist:

    i) eine erste Adhäsionsschicht (2) aus einem ersten Metall, die direkt auf die erste und die zweite Fläche aufgebracht ist,
    ii) eine Diffusionsbarriereschicht (3) aus einer nichtmetallischen Verbindung eines zweiten Metalls, die direkt auf die erste Adhäsionsschicht auf die erste und die zweite Fläche aufgebracht ist,
    iii) eine zweite Adhäsionsschicht (4) aus einem dritten Metall, die direkt auf die Diffusionsbarriereschicht aus der nichtmetallischen Verbindung des zweiten Metalls auf die erste und die zweite Fläche aufgebracht ist,
    iv) eine erste Bindungsschicht (5) aus einem Metall A, die direkt auf die zweite Adhäsionsschicht auf die erste und die zweite Fläche aufgebracht ist, und
    v) eine zweite Bindungsschicht (6) aus einem Metall B, die direkt auf die erste Bindungsschicht auf die erste und die zweite Fläche aufgebracht ist,

wobei

- die nichtmetallische Verbindung des zweiten Metalls entweder ein Nitrid oder ein Oxid des zweiten Metalls ist,
- der Schmelzpunkt des Metalls A höher ist als der des Metalls B und das Metall B chemisch reaktiv gegenüber dem Metall A an ihrer gemeinsamen Schnittstelle ist, wenn sie einem Erwärmen über den Schmelzpunkt des Metalls B ausgesetzt sind, und
- die Fest-Flüssig-Interdiffusionsbindungen gebildet wurden durch ein Legen der zweiten Bindungsschicht aus dem Metall B der thermoelektrischen Elemente und der elektrischen Kontaktelemente jeweils einander zugewandt und in Kontakt miteinander, gefolgt von einem Glühen, das das Metall B der zweiten Bindungsschicht veranlasst, zu schmelzen und mit dem Metall A der ersten Bindungsschicht zu reagieren.

11. Thermoelektrische Vorrichtung nach Anspruch 10, wobei das halbleitende thermoelektrische Umwandlungsmaterial ein gefülltes oder nichtgefülltes $CoSb_3$-basiertes Skutterudit ist.

12. Thermoelektrische Vorrichtung nach einem der Ansprüche 10-11, wobei das erste Metall der ersten Adhäsionsschicht und das zweite Metall der zweiten Adhäsionsschicht aus demselben elementaren Metall bestehen, und wobei die nichtmetallische Verbindung des zweiten Metalls der Diffusionsbarriereschicht ein Nitrid oder ein Oxid desselben elementaren Metalls ist wie das des ersten und des zweiten Metalls.

13. Thermoelektrische Vorrichtung nach Anspruch 12, wobei das elementare Metall des ersten Metalls der ersten Adhäsionsschicht und des zweiten Metalls der zweiten Adhäsionsschicht eines ist von Cr, Cu, Sn, Ta und Ti, und die nichtmetallische Verbindung des zweiten Metalls der Diffusionsbarriereschicht ein Nitrid oder ein Oxid von einem ist von Cr, Cu, Sn, Ta und Ti.

14. Thermoelektrische Vorrichtung nach einem der Ansprüche 10-13, wobei das Metall A der ersten Bindungsschicht eines von den folgenden elementaren Metallen ist: Au, Ag, Cu, Ni, Ni-V-Legierung mit von 6,5 bis 7,5 Atom-% V, und das Metall B der zweiten Bindungsschicht eines von den folgenden elementaren Metallen ist: In oder Sn.

15. Thermoelektrische Vorrichtung nach einem der Ansprüche 10-14, wobei das erste und das zweite Metall Ti von wenigstens 99,5 Gew.-% Reinheit sind, wobei die nichtmetallische Verbindung des zweiten Metalls der Diffusionsbarriereschicht TiN ist, wobei das Metall A der ersten Bindungsschicht Ni ist und das Metall B der zweiten Bindungsschicht Sn ist.

16. Thermoelektrische Vorrichtung nach einem der Ansprüche 10-15, wobei:

- die Dicke der ersten Adhäsionsschicht sich in einem der folgenden Bereiche befindet: von 20 nm bis 2 $\mu$m, von 50 nm bis 1,5 $\mu$m, von 100 nm bis 1,5 $\mu$m, von 200 nm bis 1,5 $\mu$m oder von 500 nm bis 1,5 $\mu$m,
- die Dicke der Diffusionsbarriereschicht sich in einem der folgenden Bereiche befindet: von 50 bis 5000 nm, von 75 bis 3000 nm, von 100 bis 2000 nm, von 150 bis 1000 nm, von 150 bis 750 nm, von 200 bis 500 nm, von 200 bis 400 nm oder von 200 bis 300 nm,
- die Dicke der zweiten Adhäsionsschicht sich in einem der folgenden Bereiche befindet: von 20 nm bis 1000 nm, von 30 nm bis 750 nm, von 40 nm bis 500 nm, von 100 nm bis 400 nm oder von 150 nm bis 300 nm,
- die Dicke der ersten Bindungsschicht aus dem Metall A sich in einem der folgenden Bereiche befindet: von 1 $\mu$m bis 1 cm, von 1 $\mu$m bis 0,5 cm, von 1 $\mu$m bis 0,1 cm, von 2 $\mu$m bis 500 $\mu$m, von 2 $\mu$m bis 100 $\mu$m, von 2 $\mu$m bis 50 $\mu$m oder von 3 $\mu$m bis 10 $\mu$m, und
- die Dicke der zweiten Bindungsschicht aus dem Metall B sich in einem der folgenden Bereiche befindet: von 300 nm bis 0,75 cm, von 300 nm bis 0,3 cm, von 300 nm bis 750 $\mu$m, von 200 nm bis 400 $\mu$m, von 200 nm bis 75 $\mu$m, von 200 nm bis 30 $\mu$m oder von 300 nm bis 3 $\mu$m.

17. Thermoelektrische Vorrichtung nach einem der Ansprüche 10-16, ferner umfassend eine 10 bis 50 nm dicke Schicht von Au, die direkt auf eines von der ersten Adhäsionsschicht, der zweiten Adhäsionsschicht oder der ersten Bindungsschicht, oder zwei oder mehrere davon aufgebracht ist.

## Revendications

1. Procédé pour former un matériau de conversion thermoélectrique semi-conducteur prétraité (1) pour métallisation, interconnexion et soudage, dans lequel le procédé comprend les étapes de traitement suivantes dans l'ordre successif :

- l'emploi d'au moins un élément d'un matériau de conversion thermoélectrique semi-conducteur dopé de type n ou de type p ayant des première et seconde surfaces sur des côtés opposés,
- le placement de l'au moins un élément de matériau de conversion thermoélectrique semi-conducteur dans une chambre de dépôt, puis :

i) le dépôt d'une première couche d'adhérence (2) d'un premier métal directement sur la première et la deuxième surface de l'élément du matériau de conversion thermoélectrique semi-conducteur,
ii) le dépôt d'une couche barrière à la diffusion (3) d'un composé non métallique d'un deuxième métal directement sur la première couche d'adhérence sur les première et deuxième surfaces de l'élément de matériau de conversion thermoélectrique semi-conducteur,
iii) le dépôt d'une deuxième couche d'adhérence (4) d'un troisième métal directement sur la couche barrière à la diffusion du composé non métallique du deuxième métal sur les première et deuxième surfaces de l'élément du matériau de conversion thermoélectrique semi-conducteur,

dans lequel
- la chambre de dépôt est soit une chambre de dépôt chimique en phase vapeur, une chambre de dépôt physique en phase vapeur ou une chambre de dépôt atomique, et le dépôt des différentes couches des étapes i) à iii) est obtenu en introduisant des gaz précurseurs ayant une composition chimique variable dans la chambre de dépôt,

- le composé non métallique du deuxième métal est soit un nitrure soit un oxyde du deuxième métal,

- le dépôt d'une première couche de soudage (5) d'un métal A directement sur la deuxième couche d'adhérence sur les première et deuxième surfaces d'élément du matériau de conversion thermoélectrique semi-conducteur, et

- le dépôt d'une deuxième couche de soudage (6) d'un métal B directement sur la première couche de soudage sur les première et deuxième surfaces de l'élément du matériau de conversion thermoélectrique semi-conducteur,

dans lequel

- le point de fusion du métal A est supérieur à celui du métal B et le métal B est chimiquement réactif vers le métal A au niveau de leur interface commune quand il est soumis à du chauffage au-dessus du point de fusion du métal B formant un composé intermétallique en interdiffusion solide-liquide.

2. Procédé selon la revendication 1, dans lequel le matériau de conversion thermoélectrique semi-conducteur est une skuttérudite à base de $CoSb_3$ chargée ou non chargée.

3. Procédé selon l'une quelconque des revendications 1-2, dans lequel le premier métal de la première couche d'adhérence et le deuxième métal de la deuxième couche d'adhérence sont du même métal élémentaire, et où le composé non métallique du deuxième métal de la couche barrière à la diffusion est un nitrure ou un oxyde du même métal élémentaire que les premier et deuxième métaux.

4. Procédé selon la revendication 3, dans lequel le métal élémentaire du premier métal de la première couche d'adhérence et du deuxième métal de la deuxième couche d'adhérence est l'un parmi du Cr, du Cu, du Sn, du Ta et du Ti, et le composé non métallique du deuxième métal de la couche barrière à la diffusion est un nitrure ou un oxyde de l'un parmi du Cr, du Cu, du Sn, du Ta et du Ti.

5. Procédé selon l'une quelconque des revendications 1-4, dans lequel le métal A de la première couche de soudage est l'un des métaux élémentaires suivants : Au, Ag, Cu, Ni, alliage de Ni-V avec de 6,5 à 7,5 % atomique de V, et le métal B de la deuxième couche de soudage est l'un des métaux élémentaires suivants : In ou Sn.

6. Procédé selon l'une quelconque des revendications 1-5, dans lequel les premier et deuxième métaux sont du Ti d'au moins 99,5 % en poids de pureté, le composé non métallique du deuxième métal de la couche barrière à la diffusion est du TiN, le métal A de la première couche de soudage est du Ni et le métal B de la deuxième couche de soudage est du Sn.

7. Procédé selon l'une quelconque des revendications 1-6, dans lequel :

- l'épaisseur de la première couche d'adhérence est dans l'une des plages suivantes : de 20 nm à 2 μm, de 50 nm à 1,5 μm, de 100 nm à 1,5 μm, de 200 nm à 1,5 μm, ou de 500 nm à 1,5 μm,
- l'épaisseur de la couche barrière à la diffusion est dans l'une des plages suivantes : de 50 à 5000 nm, de 75 à 3000 nm, de 100 à 2000 nm, de 150 à 1000 nm, de 150 à 750 nm, de 200 à 500 nm, de 200 à 400 nm ou de 200 à 300 nm,
- l'épaisseur de la deuxième couche d'adhérence est dans l'une des plages suivantes : de 20 nm à 1000 nm, de 30 nm à 750 nm, de 40 nm à 500 nm, de 100 nm à 400 nm, ou de 150 nm à 300 nm,
- l'épaisseur de la première couche de soudage du métal A est dans l'une des plages suivantes : de 1 μm à 1 cm, de 1 μm à 0,5 cm, de 1 μm à 0,1 cm, de 2 μm à 500 μm, de 2 μm à 100 μm, de 2 μm à 50 μm, ou de 3 μm à 10 μm, et
- l'épaisseur de la deuxième couche de soudage du métal B est dans l'une des plages suivantes : de 300 nm à 0,75 cm, de 300 nm à 0,3 cm, de 300 nm à 0,3 cm, de 300 nm à 750 μm, de 200 nm à 400 μm, de 200 nm à 75 μm, de 200 nm à 30 μm, ou de 300 nm à 3 μm.

8. Procédé selon l'une quelconque des revendications 1-7, dans lequel le procédé comprend en outre le dépôt d'une couche d'Au de 10 à 50 nm d'épaisseur directement sur l'une de la première couche d'adhérence, de la deuxième couche d'adhérence ou de la première couche de soudage, ou de deux ou plus de celles-ci.

9. Procédé selon l'une quelconque des revendications 1-8, dans lequel les première et deuxième couches de soudage de métal A et B, respectivement, sont déposées en :

- déposant par dépôt en phase vapeur la première couche de soudage d'un métal A directement sur la deuxième couche d'adhérence sur les première et deuxième surfaces d'élément de matériau de conversion thermoélectrique semi-conducteur et la deuxième couche de soudage d'un métal B directement sur la première couche d'adhérence sur les première et deuxième surfaces de l'élément de matériau de conversion thermoélectrique semi-conducteur dans la même chambre de dépôt en phase vapeur appliquée pour le dépôt de la première couche d'adhérence, de la couche barrière à la diffusion et de la structure de deuxième couche d'adhérence,

ou en :

- déposant les première et deuxième couches de soudage par dépôt électrolytique ou par dépôt autocatalytique.

10. Dispositif thermoélectrique, comprenant :

- un nombre de N éléments thermoélectriques (1) de matériau de conversion thermoélectrique semi-conducteur dopé à conductivité de type n et un nombre de N éléments thermoélectriques (1) de matériau de conversion thermoélectrique semi-conducteur dopé à conductivité de type p, où N est un entier de 1 à n,
- un nombre de 2N+1 d'éléments de contact électriques (30) comprenant une première couche de soudage (31) d'un métal A et une deuxième couche de soudage (32) d'un métal B, et
- un premier substrat (50) en contact thermique avec un réservoir de chaleur et un deuxième substrat (51) en contact thermique avec un dissipateur de chaleur,

où

- les N éléments thermoélectriques de conductivité de type n et les N éléments thermoélectriques de conductivité de type p sont électriquement connectés en série par les 2N+1 éléments de contact électriques,
- les éléments thermoélectriques sont soudés aux éléments de contact électriques par des soudures à interdiffusion liquide-solide, et
- les éléments thermoélectriques sont sur un premier côté en contact thermique avec le premier substrat en contact thermique avec un réservoir de chaleur, et sur un deuxième côté opposé au premier côté, les éléments thermoélectriques sont sur un deuxième côté opposé au premier côté en contact thermique avec le deuxième substrat en contact thermique avec un dissipateur de chaleur,

dans lequel

- chacun des N éléments thermoélectriques de conductivité de type n et des N éléments thermoélectriques de conductivité de type p a sur ses première et deuxième surfaces :

    i) une première couche d'adhérence (2) d'un premier métal déposée directement sur les première et deuxième surfaces ;
    ii) une couche barrière à la diffusion (3) d'un composé non métallique d'un deuxième métal déposée directement sur la première couche d'adhérence sur les première et deuxième surfaces,
    iii) une deuxième couche d'adhérence (4) d'un troisième métal déposée directement sur la couche barrière à la diffusion du composé non métallique du deuxième métal sur les première et deuxième surfaces,
    iv) une première couche de soudage (5) d'un métal A déposée directement sur la deuxième couche d'adhérence sur les première et deuxième surfaces, et
    v) une deuxième couche de soudage (6) d'un métal B déposée directement sur la première couche d'adhérence sur les première et deuxième surfaces,

où

- le composé non métallique du deuxième métal est soit un nitrure soit un oxyde du deuxième métal,
- le point de fusion du métal A est supérieur à celui du métal B et le métal B est chimiquement réactif vers le métal A au niveau de leur interface commune quand il est soumis à du chauffage au-dessus du point de fusion du métal B, et
- les soudures à interdiffusion solide-liquide ont été formées par l'agencement de la deuxième couche de soudage de métal B des éléments thermoélectriques et des éléments de contact électriques, respectivement, face à face et en contact mutuel suivi d'un recuit qui amène le métal B de la deuxième couche de soudage à fondre et la réaction avec le métal A de la première couche de soudage.

11. Dispositif thermoélectrique selon la revendication 10, dans lequel le matériau de conversion thermoélectrique semi-conducteur est une skuttérudite à base de $CoSb_3$ chargée ou non chargée.

12. Dispositif thermoélectrique selon l'une quelconque des revendications 10-11, dans lequel le premier métal de la première couche d'adhérence et le deuxième métal de la deuxième couche d'adhérence sont du même métal élémentaire, et où le composé non métallique du deuxième métal de la couche barrière à la diffusion est un nitrure ou un oxyde du même métal élémentaire que les premier et deuxième métaux.

13. Dispositif thermoélectrique selon la revendication 12, dans lequel le métal élémentaire du premier métal de la première couche d'adhérence et du deuxième métal de la deuxième couche d'adhérence est l'un parmi du Cr, du Cu, du Sn, du Ta et du Ti, et le composé non métallique du deuxième métal de la couche barrière à la diffusion est un nitrure ou un oxyde de l'un parmi du Cr, du Cu, du Sn, du Ta et du Ti.

14. Dispositif thermoélectrique selon l'une quelconque des revendications 10-13, dans lequel le métal A de la première couche de soudage est l'un des métaux élémentaires suivants : Au, Ag, Cu, Ni, alliage de Ni-V avec de 6,5 à 7,5 % atomique de V, et le métal B de la deuxième couche de soudage est l'un des métaux élémentaires suivants : In ou Sn.

15. Dispositif thermoélectrique selon l'une quelconque des revendications 10-14, dans lequel les premier et deuxième métaux sont du Ti d'au moins 99,5 % en poids de pureté, le composé non métallique du deuxième métal de la couche barrière à la diffusion est du TiN, le métal A de la première couche de soudage est du Ni et le métal B de la deuxième couche de soudage est du Sn.

16. Dispositif thermoélectrique selon l'une quelconque des revendications 10-15, dans lequel :

- l'épaisseur de la première couche d'adhérence est dans l'une des plages suivantes : de 20 nm à 2 $\mu$m, de 50 nm à 1,5 $\mu$m, de 100 nm à 1,5 $\mu$m, de 200 nm à 1,5 $\mu$m, ou de 500 nm à 1,5 $\mu$m,
- l'épaisseur de la couche barrière à la diffusion est dans l'une des plages suivantes : de 50 à 5000 nm, de 75 à 3000 nm, de 100 à 2000 nm, de 150 à 1000 nm, de 150 à 750 nm, de 200 à 500 nm, de 200 à 400 nm ou de 200 à 300 nm,
- l'épaisseur de la deuxième couche d'adhérence est dans l'une des plages suivantes : de 20 nm à 1000 nm, de 30 nm à 750 nm, de 40 nm à 500 nm, de 100 nm à 400 nm, ou de 150 nm à 300 nm,
- l'épaisseur de la première couche de soudage du métal A est dans l'une des plages suivantes : de 1 $\mu$m à 1 cm, de 1 $\mu$m à 0,5 cm, de 1 $\mu$m à 0,1 cm, de 2 $\mu$m à 500 $\mu$m, de 2 $\mu$m à 100 $\mu$m, de 2 $\mu$m à 50 $\mu$m, ou de 3 $\mu$m à 10 $\mu$m, et
- l'épaisseur de la deuxième couche de soudage du métal B est dans l'une des plages suivantes : de 300 nm à 0,75 cm, de 300 nm à 0,3 cm, de 300 nm à 0,3 cm, de 300 nm à 750 $\mu$m, de 200 nm à 400 $\mu$m, de 200 nm à 75 $\mu$m, de 200 nm à 30 $\mu$m, ou de 300 nm à 3 $\mu$m.

17. Dispositif thermoélectrique selon l'une quelconque des revendications 10-16, comprenant en outre une couche d'Au de 10 à 50 nm d'épaisseur directement sur l'une de la première couche d'adhérence, de la deuxième couche d'adhérence ou de la première couche de soudage, ou de deux ou plus de celles-ci.

Fig. 1 a)    Facsimile of Fig. 1 of US 6 660 926

EP 3 218 941 B1

Fig. 2   a)

EP 3 218 941 B1

Fig. 2 b)    Excerpt from  Fig. 18 of US 6 660 926

a)

A

B

B

A

b)

A

B

B

A

c)

A

AB

A

Fig. 3

EP 3 218 941 B1

Fig. 4

Fig. 5

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6660926 B
- WO 2011014479 A
- US 6673996 B
- US 6759586 B
- WO 2012071173 A
- EP 2242121 A
- US 20130152990 A
- US 20140305483 A

**Non-patent literature cited in the description**

- **BADER et al.** RAPID FORMATION OF INTERME-TALLIC COMPOUNDS BY INTERDIFFUSION IN THE Cu-Sn AND Ni-Sn SYSTEMS. *Acta metall, mater.,* 1994, vol. 43 (1), 329-337